# EUROPEAN PATENT APPLICATION

(11) **EP 1 841 300 A1**
(43) Date of publication of application: **03.10.2007**
(21) Application number: 07006385.4
(22) Date of filing: 28.03.2007
(51) Int. Cl.: H05K 1/16

(54) **Conductive base material with thin film resistance layer, method of production of conductive base material with thin film resistance layer, and circuit board with thin film resistance layer**

(30) Priority: 29.03.2006 JP 2006091356
(71) Applicant: FURUKAWA CIRCUIT FOIL CO., LTD., Tochigi-ken 321-2336 (JP); The Furukawa Electric Co., Ltd., Chiyoda-ku, Tokyo 100-8322 (JP)
(72) Inventor: Kikuchi, Yuuki, Nikko-city, Tochigi-ken 321-2336 (JP); Suzuki, Yuuji, Nikko-city, Tochigi-ken 321-2336 (JP); Matsumoto, Sadao, Nikko-city, Tochigi-ken 321-2336 (JP); Zama, Satoru, Chiyoda-ku, Tokyo 100-8322 (JP); Ogiwara, Yoshiaki, Chiyoda-ku, Tokyo 100-8322 (JP)
(74) Representative: Benedum, Ulrich Max

(57) **Abstract**

An inexpensive conductive base material with a thin film resistance layer having small variation of the sheet resistance value and a conductive base material with a resistance layer enabling production of a printed resistor circuit board by stably leaving behind resistance elements, that is, a conductive base material with a thin film resistance layer comprised of a conductive base material having a resistance layer formed on its surface wherein the resistance layer includes Ni containing P and an amorphous and a crystalloid form are mixed together and a conductive base material with a thin film resistance layer comprised of a conductive base material having a resistance layer formed on its surface wherein the resistance layer is a crystalline thin film resistance layer including Ni containing P.

## Description

### BACKGROUND OF THE INVENTION

### 1. Field of the Invention

The present invention relates to a conductive base material with a thin film resistance layer useful in preparation of a printed resistor circuit board etc., a method of production of a conductive base material with a thin film resistance layer, and a circuit board with a thin film resistance layer to which a conductive base material with a thin film resistance layer is bonded.

### 2. Description of the Related Art

A printed circuit board material having a built-in resistor (hereinafter referred to as a "circuit board material with a resistance layer") is generally provided in a form of a laminate of an insulating substrate and a conductive base material with a resistance layer comprised of a resistance layer bonded onto a conductive substrate etc. and a good conductive base material such as copper foil bonded to the resistance layer.

In a resistor circuit using a circuit board material with a resistance layer, insulating regions (regions where all of the conductive base material with the resistance layer on the insulating substrate is removed), resistance regions (regions where the good conductive base material is removed), and conductive regions (regions where everything is left intact) are formed by the subtractive method (mask etching method) according to the patterns of the intended circuit.

Conventionally, as the material for forming the resistance layer, a carbon-based resistance material has generally been used. Further, other than this, as materials utilizing metal thin films, Ni electroplating including phosphorus (see for example Japanese Patent Publication (A) No. 48-73762 and Japanese Patent Publication (B) No. 63-500133), Ni electroplating including Sn (see for example Japanese Patent Publication (A) No. 54-72468), and so on have been proposed.

In the production of a conventional conductive base material with a thin film resistance layer as described above, the thin film resistance layer is formed on the conductive base material by an electroplating method. By adjusting the thickness of the thin film resistance layer, the sheet resistance value is controlled. Formation of a film having a high sheet resistance is possible by reducing the film thickness, but, generally, when reducing the film thickness, the uniformity of the metal film is lost, therefore a constant sheet resistance is not obtained. For this reason, there is a limit to the reduction of the thickness.

On the other hand, formation of a film having a low sheet resistance value is possible by increasing the film thickness. However, there are the inconveniences such as cracks when forming the resistance layer by the plating and curling of the conductive base material due to plating stress. For this reason, there is also a limit to the increase of the thickness.

Further, at the time of use as a resistor circuit substrate material, when removing the layer of the conductive base material by etching, dissolution of a part of the resistance layer can not be avoided. Further, when the thickness of the Ni-P plated resistance layer is small, there is a defect that part of the resistance layer will be missing when completely removing the layer of the conductive base material. In this way, it was extremely difficult to produce a printed resistor circuit board by stably leaving behind resistance elements.

In particular, in a resistance layer using an Ni-P alloy, the plating bath for forming the resistance layer is a bath including nickel ions, phosphorous acid ions, and phosphoric acid ions as indispensable ingredients and further including sulfuric acid ions and chlorine ions. A conductive base material with a resistance layer comprised of conductive base material plated in this type of bath suffers from uneven coloring at the time of plating and micro variations. Further, in a wide material (for example larger than 300 mm) at the time of mass production, there was the defect that variations were apt to occur in the plating thickness and the P content in its width direction, and also the variation of resistance values as the resistor circuit became large.

Further, in the case of a resistance layer using an Ni-Sn alloy mentioned before, in the etching of the resistance layer (dissolution of Ni-Sn) when forming the insulating regions, an oxide or a hydroxide of tin remained in the insulating substrate, so there was problem of poor insulation.

Further, technology forming the resistance layer by providing a layer made of Ni-Cr, Ni-Cr-Al-Si, or the like according to a vapor deposition process has been developed. However, this vapor deposition process involves not only the problems of cost and productivity, but also the problem of a low bonding strength with the insulating material is low.

### SUMMARY OF THE INVENTION

In consideration with the above conventional issues and problems, an object of the present invention is to inexpensively provide a conductive base material with a thin film resistance layer having small variation of the sheet resistance value. Further, another object thereof is to provide a conductive base material with a thin film resistance layer enabling production of a printed resistor circuit board by stably leaving behind resistance elements.

According to a first aspect of the invention, there is provided a conductive base material with a thin film resistance layer comprised of a conductive base material having a resistance layer formed on its surface, wherein the resistance layer is comprised of Ni containing P and has amorphous and crystalloid forms mixed.

According to a second aspect of the invention, there is provided a conductive base material with a thin film resistance layer comprised of a conductive base material having a resistance layer formed on its surface, wherein the resistance layer is a crystalline thin film resistance layer comprised of Ni containing P.

According to a third aspect of the invention, there is provided a method of production of a conductive base material with a thin film resistance layer comprising forming an Ni plating thin film layer containing P on at least one surface of the conductive base material and heat treating the thin film layer to thereby form a thin film resistance layer having amorphous and crystalloid forms mixed.

According to a fourth aspect of the invention, there is provided a method of production of a conductive base material with a thin film resistance layer comprising forming an Ni plating thin film layer containing P on at least one surface of the conductive base material and heat treating the thin film layer to thereby form a crystalline thin film resistance layer.

Preferably, the resistance layer is comprised of a plating layer of Ni containing P and forms a resistance layer having amorphous and crystalloid forms mixed by the heat treatment of the plating layer.

Further, preferably, the resistance layer is comprised of a plating layer of Ni containing P and forms a crystalline resistance layer by the heat treatment of the plating layer.

Preferably, the heat treatment is carried out at 100°C to 700°C.

The P content of the Ni resistance layer containing the P is 1 to 30 wt%.

According to a fifth aspect of the invention, there is provided a circuit board with a thin film resistance layer comprised of an insulating substrate on at least one surface of which a conductive base material with a thin film resistance layer is bonded with the resistance layer at the inside, wherein the conductive base material with the thin film layer is comprised of a conductive base material having a resistance layer formed on the surface, and the resistance layer is a thin film resistance layer comprised of Ni containing P and having amorphous and crystalloid forms mixed.

According to a sixth aspect of the invention, there is provided a circuit board with a thin film resistance layer comprised of an insulating substrate on at least one surface of which a conductive base material with a thin film resistance layer is bonded with the resistance layer at the inside, wherein the conductive base material with the thin film layer is comprised of a conductive base material having a resistance layer formed on its surface, and the resistance layer is a crystalline thin film resistance layer comprised of Ni containing P.

The present invention can cheaply provide a conductive base material with a thin film resistance layer having small variation of the sheet resistance value. Further, it can provide a conductive base material with a thin film resistance layer enabling production of a printed resistor circuit board by stably leaving behind resistance elements.

### DESCRIPTION OF THE PREFERRED EMBODIMENTS

In the present invention, the surface of a conductive substrate is plated with an Ni plating containing P so as to form a resistance layer having an amorphous and crystalloid forms mixed or form a resistance layer comprised of only the crystalloid form. The resistance value of this resistance layer is controlled by heat treatment. By controlling the resistance value by heat treatment, the conventional defect of the variation of the resistance value is eliminated and, at the same time, the stability of the resistance value is improved.

As the plating bath and plating conditions when plating the resistance layer onto a conductive base material of the present invention, a known Ni plating bath such as a sulfuric acid plating bath and sulfamic acid plating bath can be employed. Between these, from the viewpoint of the cost, a sulfuric acid bath is superior. Further, from the viewpoint of a uniform electrodeposition property, a sulfamic acid bath is superior. Accordingly, the plating bath is selected according to the required properties of the thin film resistance layer.

As plating bath composition, preferably
the Ni sulfate is within a range of 100 to 200 g/1, and
the Ni sulfamate is within a range of 300 to 600 g/1.

The phosphoric acid, the phosphorous acid, and hypophosphoric acid to be added to the plating bath can be used as they are. Na salt (sodium salt) etc. can be used too in place of them.

The concentration of P is preferably within a range of 20 to 150 g/l. However, when considering prevention of crystallization when the liquid temperature is lowered when for example the equipment is not being operated, a range of 20 to 100 g/l is preferred.

In the above plating bath, the pH is adjusted by using an Na salt etc. Other than this, an alkali such as NaOH or an acid such as sulfamic acid or sulfuric acid may be added to adjust the pH. The higher the pH, the poorer the uniformity of the plating film. For this reason, desirably the pH is adjusted to 6 or less. Further, when the pH is adjusted to 4 or less, the pH fluctuation becomes small, so this is more preferred.

Further, as the plating bath, the stability of the pH increases by including a pH buffer such as boric acid, therefore a thinner film composition and more stable current efficiency can be achieved.

Further, by adding sulfuric acid or hydrochloric acid or salts of these to the plating bath, the smoothness and processability of the plating film can be improved. As the concentration thereof, 0.1 to 30 g/l is suitable. If exceeding this, the hardness and internal stress rise, so this is not preferred.

A bath temperature within a range of 30 to 80°C is preferred from viewpoint of the current efficiency and the stability of the P content. Note that when exceeding 70°C, the sulfamic acid is gradually hydrolyzed. For this reason, from the viewpoint of the service life of the bath, 70°C or less is more desirable. Further, the lower the temperature, the lower the current efficiency. For this reason, 45°C or more is more desirable.

A current density of 1 to 30 A/dm² is good. If exceeding this, a drop in the current efficiency and deterioration of the smoothness are liable to occur.

As an anode, a soluble anode such as Ni, Ni-P alloy, and Ni-Cu-P alloy can be used too. However, a soluble anode is dissolved and consumed at the time of long plating, a change of the distance from a cathode (conductive base material) occurs, and the macro plating thickness distribution is deteriorated. Further, due to the difference of the current efficiency between the anode and the cathode, the Ni concentration in the bath increases. For this reason, the solution must be drained and the cost becomes high. For these reasons, the use of an insoluble anode is desirable.

As an insoluble anode, use can be made of known materials such as platinum plated titanium plate and an iridium oxide coated plate.

Note that when using an insoluble anode, the amount of Ni in the plating bath is reduced. For this reason, it is necessary to resupply Ni. For this resupply, desirably an Ni salt such as Ni carbonate is desirable.

Further, in the use of an insoluble anode, hypophosphorous acid changes to phosphorous acid or phosphoric acid by an electrolytic reaction. For this reason, for the stabilization of a precipitated film, the use of a phosphorous acid or a phosphoric acid is more preferred than the use of a hypophosphorous acid.

The method for plating the resistance layer on the conductive base material of the present invention need not only be by electroplating. It may also be formed by the electroless plating method. Typical electroless plating baths are shown below.

| Acidic Ni-P plating bath | |
|---|---|
| Nickel sulfate | 20 to 50 g/l |
| Sodium phosphinate | 10 to 50 g/l |
| Sodium acetate | 5 to 20 g/l |
| Sodium citrate | 5 to 20 g/l |
| pH | 3 to 6 |
| Bath temperature | 70 to 90°C |

| Alkaline Ni-P plating bath | |
|---|---|
| Nickel sulfate | 20 to 50 g/l |
| Sodium phosphinate | 10 to 50 g/l |
| Ammonium chloride | 20 to 50 g/l |
| Sodium citrate | 10 to 80 g/l or |
| Sodium pyrophosphate | 20 to 70 g/l |
| pH | 3 to 6 |
| Bath temperature | 40 to 80°C |

As the thin film of the resistance layer formed here, when P is 1 to 30 wt%, a high resistance is obtained, and the etching property is good. Particularly, when the content is 8 to 18 wt%, the resistance and the etching property are further stabilized, and the variation in resistance due to the solution after the etching of the conductive base material (for example copper foil) is small. A thickness within a range from 0.1 mg/dm² to 50 mg/dm² converted to weight. Further, the concentration of the P and the thickness of the layer can be adjusted so that the desired resistance value is obtained.

Note that after forming the thin film resistance layer, surface treatment such as Zn, chromate, and silane treatment may be suitably carried out.

As the heat treatment condition, by performing the heat treatment at 100 to 700°C within the ranges of the thickness of the thin film resistance layer and the P content described above, amorphous and crystalloid forms result. In the case of less than 100°C, a composite is obtained. In the case of more than 700°C, the thin film resistance layer becomes brittle. Then, the formation of the resistors becomes difficult.

As the sheet resistance value of the thin film resistance layer after the heat treatment, the resistance stability is good within a range from 10 Ω/□ to 1,000 Ω/□. Particularly, within a range from 10 Ω/□ to 500 Ω/□, the resistance and the etching property become further stable.

Further, as to the Vickers hardness (Hv) of the thin film resistance layer after the heat treatment, the plating becomes stable within a range of 200 to 1,000.

Further, when the surface roughness of the conductive base material before the plating is too rough, the surface roughness of the resistance layer formed on that becomes rough as well, and it becomes difficult to make the resistance layer uniform. For this reason, variation easily occurs in the plating thickness. Further, at the time of hot pressing after the etching of the substrate material when it is used as the resistor circuit board material, the stress easily concentrates at the thin film resistance layer due to its unevenness, and cracking easily occurs. For this reason, the surface roughness of the conductive base material before the plating is preferably 3.5 µm or less. Particularly, from the viewpoint of the processability, a roughness of 2.5 µm or less is more preferred.

However, when considering the bondability with a resin base material, the roughness is preferably controlled to 0.3 µm or more.

An embodiment of the method of production of a resistor circuit board material according to the present invention is explained next.

First, as the conductive base material, for example, one entire surface of a copper foil is covered by a masking use bonding sheet, ink, or the like. Then, as the resistance layer, the above alloy plating layer is formed on the other surface. Thereafter, the masking use bonding sheet or the like is peeled off. Then, the insulating substrate is heat pressed to the resistance layer side or bonded by a binder.

To form a printed resistor circuit board from this resistor circuit board material, for example, the dissolution method is used to form the insulating regions (regions where all of the conductive base material with the resistance layer on the insulating substrate is removed), resistance regions (regions where the good conductive base material is removed), and conductive regions (regions where everything is left intact). After the formation of the circuit, according to need, the surfaces of the resistance regions and the conductive regions are formed with a protective layer by a liquid state or film state cover coating.

In the above processing, as the etching solution, use can be made of known solutions. For example, in the case of copper foil, use is made of ferric chloride, cupric chloride, ammonium persulfate, a mixed solution of chromic acid and sulfuric acid, and an ammonium chelate-based etching solution etc.

As the etching solution of an Ni alloy resistance layer, use can be made of known solutions such as a copper sulfate-sulfuric acid solution, ferric sulfate-sulfuric acid solution, and ammonium persulfate-sulfuric acid solution.

As the conductive material constituting the conductive base material with a resistance layer of the present invention, preferably use is made of a copper foil made by electrolysis or rolling or a foil having a high conductivity such as a copper alloy foil, aluminum foil, aluminum alloy foil, and iron alloy foil. A copper foil is the best from the viewpoints of removal by etching and recycling.

As the insulating substrate, use may be made of any of an epoxy resin, polyester, polyimide, polyamide imide, or composite material comprised of any of these and a glass cloth and a laminate sheet such as phenol resin-paper and epoxy resin-paper. Further, as a heat sink, use is made of the above various types of insulating laminate sheets obtained by bonding aluminum or iron plate (bonded to an opposite surface to the surface for provision of the resistance layer), sheet, or films.

Further, as the insulating substrate, use can also be made of ceramic sheet, glass sheet, or other inorganic material using epoxy resin, polyester, polyurethane, polyamide imide, polyimide, rubber, or other resin as a binder layer.

### EXAMPLES

Below, the present invention will be more specifically explained according to examples.

As the conductive base material, use was made of an electrolytic copper foil having a thickness of 18 µm and having a roughened matte surface. The shiny surface was masked over its entirety and the matte surface was masked to leave 10 x 10 cm. As the counter electrode (anode), use was made of a platinum plated titanium sheet having a surface area of 1.5 dm². The resistance layer was plated on the matte surface in a known Ni plating bath such as the sulfuric acid plating bath or sulfamic acid plating bath mentioned before. The heat treatment was carried out in a nitrogen atmosphere, and the treatment was carried out from a time after when the material temperature reached the heat treatment temperature of each example. As the plating thickness, the Ni electrodeposition amount (mg/dm²), the P content (%), the sheet resistance value (Ω/□) at 1 mm□ after the circuit formation, the sheet resistance value variation (%), and the Vickers hardness: Hv were measured. The results are shown in Table 1.

### Example 1

The conductive base material was plated to obtain the following Ni thickness and P content. Thereafter, the heat treatment was carried out under the following heat treatment conditions.
Ni thickness: 0.1 mg/dm²
P content: 11 wt%
Heat treatment condition: 400°C x 1 hr

### Example 2

The plating was carried out and the heat treatment was carried out under the following conditions in the same way as Example 1.
Ni thickness: 1.0 mg/dm²
P content: 11 wt%
Heat treatment condition: 400°C x 1 hr

### Example 3

The plating was carried out and the heat treatment was carried out under the following conditions in the same way as Example 1.
Ni thickness: 5.0 mg/dm²
P content: 11 wt%
Heat treatment condition: 400°C x 1 hr

### Example 4

The plating was carried out and the heat treatment was carried out under the following conditions in the same way as Example 1.
Ni thickness: 10.0 mg/dm²
P content: 1 wt%
Heat treatment condition: 400°C x 1 hr

### Example 5

The plating was carried out and the heat treatment was carried out under the following conditions in the same way as Example 1.
Ni thickness: 10.0 mg/dm²
P content: 5 wt%
Heat treatment condition: 400°C x 1 hr

### Example 6

The plating was carried out and the heat treatment was carried out under the following conditions in the same way as Example 1.
Ni thickness: 10.0 mg/dm²
P content: 11 wt%
Heat treatment condition: 100°C x 1 hr

### Example 7

The plating was carried out and the heat treatment was carried out under the following conditions in the same way as Example 1.
Ni thickness: 10.0 mg/dm²
P content: 11 wt%
Heat treatment condition: 200°C x 1 hr

### Example 8

The plating was carried out and the heat treatment was carried out under the following conditions in the same way as Example 1.
Ni thickness: 10.0 mg/dm²
P content: 11 wt%
Heat treatment condition: 400°C x 1 hr

### Example 9

The plating was carried out and the heat treatment was carried out under the following conditions in the same way as Example 1.
Ni thickness: 10.0 mg/dm²
P content: 11 wt%
Heat treatment condition: 700°C x 1 hr

### Example 10

The plating was carried out and the heat treatment was carried out under the following conditions in the same way as Example 1.
Ni thickness: 10.0 mg/dm²
P content: 17 wt%
Heat treatment condition: 400°C x 1 hr

### Example 11

The plating was carried out and the heat treatment was carried out under the following conditions in the same way as Example 1.
Ni thickness: 10.0 mg/dm²
P content: 30 wt%
Heat treatment condition: 400°C x 1 hr

### Example 12

The plating was carried out and the heat treatment was carried out under the following conditions in the same way as Example 1.
Ni thickness: 15.0 mg/dm²
P content: 11 wt%
Heat treatment condition: 400°C x 1 hr

### Example 13

The plating was carried out and the heat treatment was carried out under the following conditions in the same way as Example 1.
Ni thickness: 30.0 mg/dm²
P content: 11 wt%
Heat treatment condition: 400°C x 1 hr

### Example 14

The plating was carried out and the heat treatment was carried out under the following conditions in the same way as Example 1.
Ni thickness: 50.0 mg/dm²
P content: 11 wt%
Heat treatment condition: 400°C x 1 hr

### Comparative Example 1

The conductive base material was plated so that the following Ni thickness and P content were obtained, then the heat treatment was carried out under the following heat treatment conditions in the same way as Example 1.
Ni thickness: 0.01 mg/dm²
P content: 11 wt%
Heat treatment condition: 400°C x 1 hr

### Comparative Example 2

The plating was carried out and the heat treatment was carried out under the following conditions in the same way as Comparative Example 1.
Ni thickness: 10.0 mg/dm²
P content: 0.1 wt%
Heat treatment condition: 400°C x 1 hr

### Comparative Example 3

The plating was carried out and the heat treatment was carried out under the following conditions in the same way as Comparative Example 1.
Ni thickness: 70.0 mg/dm²
P content: 11 wt%
Heat treatment condition: 400°C x 1 hr

### Comparative Example 4

The plating was carried out and the heat treatment was carried out under the following conditions in the same way as Comparative Example 1.
Ni thickness: 10.0 mg/dm²
P content: 11 wt%
Heat treatment condition: No heat treatment

### Comparative Example 5

The conductive base material was sputtered to obtain the following Ni thickness and P content, then heat treatment was carried out under the following heat treatment conditions.
Ni thickness: 10.0 mg/dm²
P content: 11 wt%
Heat treatment condition: 400°C x 1 hr

The results are shown in the following Table 1. In Table 1, first, the plating thickness is measured by dissolving the surface, obtaining the amounts of deposition of Ni and P and preparing a calibration line for a fluorescent X-ray thickness tester from the data above, which is then used for following measurements of the samples. Accordingly, the thickness value for the apparent surface area was, in the case of Ni, 89 mg/dm² or roughly corresponding to 1 µm.

**Table 1**

| | Ni thickness (mg/dm²) | P content (wt%) | Heat treatment conditon (°C x 1hr) | Sheet resistance value (Ω/□) | Sheet resistance variation (%) | Vickers hardness (Hv) | Resistance layer crystal form | Resistance layer composition |
|---|---|---|---|---|---|---|---|---|
| Example 1 | 0.1 | 11 | 400 | 500 | ±10% | 700 | Amorphous + crystalloid | Ni-P alloy |
| Example 2 | 1.0 | 11 | 400 | 250 | ±9% | 700 | Amorphous + crystalloid | Ni-P alloy |
| Example 3 | 5.0 | 11 | 400 | 80 | ±9% | 700 | Amorphous + crystalloid | Ni-P alloy |
| Example 4 | 10.0 | 1 | 400 | 50 | ±13% | 500 | Amorphous + crystalloid | Ni-P alloy |
| Example 5 | 10.0 | 5 | 400 | 35 | ±11% | 600 | Amorphous + crystalloid | Ni-P alloy |
| Example 6 | 10.0 | 11 | 100 | 40 | ±17% | 350 | Amorphous + crystalloid | Ni-P alloy |
| Example 7 | 10.0 | 11 | 200 | 30 | ±13% | 400 | Amorphous + crystalloid | Ni-P alloy |
| Example 8 | 10.0 | 11 | 400 | 25 | ±10% | 700 | Amorphous + crystalloid | Ni-P alloy |
| Example 9 | 10.0 | 11 | 700 | 15 | ±5% | 900 | Crystalloid | Ni-P alloy |
| Example 10 | 10.0 | 17 | 400 | 75 | ±8% | 750 | Amorphous + crystalloid | Ni-P alloy |
| Example 11 | 10.0 | 30 | 400 | 100 | ±7% | 800 | Amorphous + crystalloid | Ni-P alloy |
| Example 12 | 15.0 | 11 | 400 | 20 | ±8% | 700 | Amorphous + crystalloid | Ni-P alloy |
| Example 13 | 30.0 | 11 | 400 | 10 | ±9% | 700 | Amorphous + crystalloid | Ni-P alloy |
| Example 14 | 50.0 | 11 | 400 | 5 | ±10% | 700 | Amorphous + crystalloid | Ni-P alloy |
| Comp. Ex. 1 | 0.01 | 11 | 400 | 750 | ±45% | 700 | Composite | - |
| Comp. Ex. 2 | 10.0 | 0.1 | 400 | 15 | ±40% | 500 | Composite | - |
| Comp. Ex. 3 | 70.0 | 11 | 400 | 3 | ±38% | 700 | Composite | - |
| Comp. Ex. 4 | 10.0 | 11 | None | 50 | ±30% | 300 | Composite | - |
| Comp. Ex. 5 | 10.0 | 11 | 400 | 25 | ±35% | 700 | Composite | - |

In the etching of the copper film, the thin film resistance layer side of the conductive base material with a thin film resistance layer prepared in each of the examples and comparative examples was covered with a glass cloth impregnated with an epoxy resin. These were bonded by heating and pressurizing using a lamination use press to thereby prepare a printed board with a resistance layer. Then, by using Neutra-Etch V-1 made by Shipley Corp., the etching (about 1 to 2 minutes) was carried out at 52°C until the copper foil was no longer seen. The resistance layer was removed by the etching under conditions of copper sulfate of 250 g/l, sulfuric acid of 5 ml/l, and 90°C.

The unit of the sheet resistance value was Ω/□ which was measured by a resistance tester Lovesta-GP of Mitsubishi Chemical Co.,Ltd.. The variation of the sheet resistance values was calculated from a mean value measured when n = 20.

The value of Vickers hardness was defined in JIS Z 2244. This was measured by the test method of Vickers hardness.

The crystal state of the thin film resistance layer was observed by dissolving away all of the Cu of the conductive base material of 200 mm ^{*} 300 mm sheet size with a thin film resistance layer prepared in each of the examples and comparative examples by a solution with sulfuric acid 60 ml/l and hydrogen peroxide 30-100 ml/1, taking a sample of the powder of Ni-P, and performing powder X-ray diffraction of θ-2θ method by Geigerflex type analyzer RAD-B of Rigaku Co.,Ltd. under the condition of X-ray acceleration of 40 kV and 20 mA. As a result of the powder X-ray diffraction, in the case of the amorphous form, a broad peak showing Ni (111) and Ni (200) appeared. But a heat treatment reduces the half peak width of Ni (111) peak and the peaks of Ni₃P (321) and Ni₃P (411) start to appear.

In the present invention, it was judged that a portion of the amorphous form was crystallized due to the appearance of the peak showing Ni₃P. The results thereof were described in Table 1.

The d-value of Ni₃P (321) is 2.161 Å and Ni₃P (321) is 1.947 Å.

As apparent from Table 1, in the resistor film not subjected to the heat treatment (Comparative Example 4), the variation of resistance value was large. However, in the resistor film subjected to the heat treatment, the variation was kept small.

Further, the Ni thickness is small in Comparative Example 1, the P content is low in Comparative Example 2, and the Ni thickness is large in Comparative Example 3. For this reason, the crystal state of the resistance layer became a composite, and the variation of sheet resistance value became large.

For Comparative Example 5, the thin film resistance layer is formed not by plating, but by sputtering. For this reason, the crystal state of the resistance layer became a composite, and the variation of sheet resistance value became large.

From the above results, in the present invention, a thin film resistance layer having a small variation of sheet resistance value can be prepared and provided.

In the above description, an explanation was given of a structure wherein a conductive base material with a thin film resistance layer was bonded to one surface of an insulating substrate. However, the circuit board with a thin film resistance layer according to the present invention can be improved and modified in terms of structure. For example, a structure in which conductive base materials with thin film resistance layers are bonded to both surfaces of the insulating substrate, and a structure in which the conductive base material with the thin film resistance layer is bonded to one surface of the insulating substrate, and a high conductive layer (for forming the conductor and/or electrode by etching) is bonded to the other may be employed. Further, naturally also a multi-layer circuit board obtained by laminating these circuit boards in multiple layers can be employed.

## Claims

1. A conductive base material with a thin film resistance layer comprised of a conductive base material having a resistance layer formed on its surface, wherein said resistance layer is comprised of Ni containing P and has amorphous and crystalloid forms mixed.

2. A conductive base material with a thin film resistance layer comprised of a conductive base material having a resistance layer formed on its surface, wherein said resistance layer is a crystalline thin film resistance layer comprised of Ni containing P.

3. A conductive base material with a thin film resistance layer as set forth in claim 1, wherein said resistance layer is comprised of a plating layer of Ni containing P and forms a resistance layer having amorphous and crystalloid forms mixed by the heat treatment of the plating layer.

4. A conductive base material with a thin film resistance layer as set forth in claim 1 or 2, wherein said resistance layer is comprised of a plating layer of Ni containing P and forms a crystalline resistance layer by the heat treatment of the plating layer.

5. A conductive base material with a thin film resistance layer as set forth in claim 3 or 4, wherein said heat treatment is carried out at 100°C to 700°C.

6. A conductive base material with a thin film resistance layer as set forth in any one of claims 1 to 5, wherein the P content of the Ni resistance layer containing said P is 1 to 30 wt%.

7. A method of production of a conductive base material with a thin film resistance layer comprising forming an Ni plating thin film layer containing P on at least one surface of the conductive base material and heat treating the thin film layer to thereby form a thin film resistance layer having amorphous and crystalloid forms mixed.

8. A method of production of a conductive base material with a thin film resistance layer comprising forming an Ni plating thin film layer containing P on at least one surface of the conductive base material and heat treating the thin film layer to thereby form a crystalline thin film resistance layer.

9. A method of production of a conductive base material with a thin film resistance layer as set forth in claim 7 or 8, wherein said heat treatment is carried out at 100°C to 700°C.

10. A method of production of a conductive base material with a thin film resistance layer as set forth in any one of claims 7 to 9, wherein the P content of the Ni resistance layer containing said P is 1 to 30 wt%.

11. A circuit board with a thin film resistance layer comprised of an insulating substrate on at least one surface of which a conductive base material with a thin film resistance layer is bonded with the resistance layer at the inside, wherein said conductive base material with the thin film layer is comprised of a conductive base material having a resistance layer formed on the surface, and said resistance layer is a thin film resistance layer comprised of Ni containing P and having amorphous and crystalloid forms mixed.

12. A circuit board with a thin film resistance layer comprised of an insulating substrate on at least one surface of which a conductive base material with a thin film resistance layer is bonded with the resistance layer at the inside, wherein said conductive base material with the thin film layer is comprised of a conductive base material having a resistance layer formed on its surface, and said resistance layer is a crystalline thin film resistance layer comprised of Ni containing P.
